Europäisches Patentamt

European Patent Office

Office européen des brevets

(19)

(11) Numéro de publication : **0 156 086**
**B1**

(12) **FASCICULE DE BREVET EUROPÉEN**

(45) Date de publication du fascicule du brevet :
02.03.88

(51) Int. Cl.⁴ : **G 01 R 33/022**

(21) Numéro de dépôt : **84402746.6**

(22) Date de dépôt : **27.12.84**

(54) **Procédé de compensation automatique des erreurs mécaniques d'un gradientmètre magnétique.**

(30) Priorité : **24.01.84 FR 8401051**

(43) Date de publication de la demande :
**02.10.85 Bulletin 85/40**

(45) Mention de la délivrance du brevet :
**02.03.88 Bulletin 88/09**

(84) Etats contractants désignés :
**DE GB IT SE**

(56) Documents cités :
**FR-A- 1 523 462**
**US-A- 4 109 199**
**US-A- 4 386 318**

(73) Titulaire : **THOMSON-CSF**
**173, Boulevard Haussmann**
**F-75379 Paris Cédex 08 (FR)**

(72) Inventeur : **Posseme, Gilles**
**THOMSON-CSF SCPI 173, bld Haussmann**
**F-75379 Paris Cedex 08 (FR)**
Inventeur : **Guillemin, Germain**
**THOMSON-CSF SCPI 173, bld Haussmann**
**F-75379 Paris Cedex 08 (FR)**

(74) Mandataire : **Desperrier, Jean-Louis et al**
**THOMSON-CSF SCPI 19, avenue de Messine**
**F-75008 Paris (FR)**

EP 0 156 086 B1

**0 156 086**

**Description**

La présente invention se rapporte aux procédés permettant de compenser automatiquement les erreurs mécaniques des dispositifs destinés à mesurer le gradient d'un champ magnétique, connus sous le nom de gradientmètres magnétiques. Elle concerne également les dispositifs permettant de mettre en œuvre ce procédé, et les gradientmètres qui en sont équipés.

Il est connu de mesurer le gradient de la composante d'un champ magnétique selon une direction déterminée sur un axe y en un point de cet axe en plaçant sur l'axe de part et d'autre de ce point deux sondes de mesure, ou magnétomètres, directives séparées par une faible distance δy. Si δHy est la différence des mesures de deux sondes, la valeur du gradient à mesurer est donnée par :

$$\frac{\delta Hy}{\delta y}$$

En plus des causes d'erreurs dues aux défauts propres aux sondes prises individuellement et à l'électronique associée, une source d'erreur importante est le défaut de colinéarité des axes de mesure des deux sondes.

La Demanderesse a proposé dans sa demande de brevet français n° 8 315 791 déposée le 4 octobre 1983 de réaliser un gradientmètre magnétique intégré dans lequel l'axe de mesure est défini par un seul faisceau lumineux qui traverse une couche mince dans son épaisseur, ce qui élimine de manière intrinsèque les erreurs d'alignement.

Un tel dispositif n'est pas adapté à toutes les configurations de mesures, notamment lorsque la distance δy n'est pas très faible. Par ailleurs on souhaite souvent, pour des raisons de coût, pouvoir associer des magnétomètres disponibles couramment afin de réaliser un gradientmètre.

Il est connu du brevet français FR-A 1 523 462 de compenser l'erreur d'alignement d'un tel gradientmètre en utilisant deux magnétomètres supplémentaires perpendiculaires entre eux et à l'axe du gradientmètre. Les signaux délivrés par ces magnétomètres supplémentaires sont traités pour délivrer des courants de compensation qui circulent dans deux bobines entourant les magnétomètres principaux du gradientmètre et y génèrent des champs magnétiques permettant la compensation des défauts d'alignement de ces magnétomètres principaux. Ce dispositif nécessite un étalonnage qui est obtenu avec deux résistances variables qui permettent de régler les courants de compensation. Toutefois ce brevet n'enseigne aucune méthode permettant de procéder à cet étalonnage. En l'absence d'une telle méthode cet étalonnage est difficile à réaliser puisque manifestement les deux réglages réagissent l'un sur l'autre.

Pour réaliser cet étalonnage rapidement et sans difficultés, l'invention propose un procédé selon les revendications 1 et 2.

D'autres particularités et avantages de l'invention apparaîtront clairement dans la description suivante faite en regard des figures annexées qui représentent :

la figure 1, un système d'axe définissant un gradientmètre ;

la figure 2, le schéma d'un gradientmètre sèlon l'invention ;

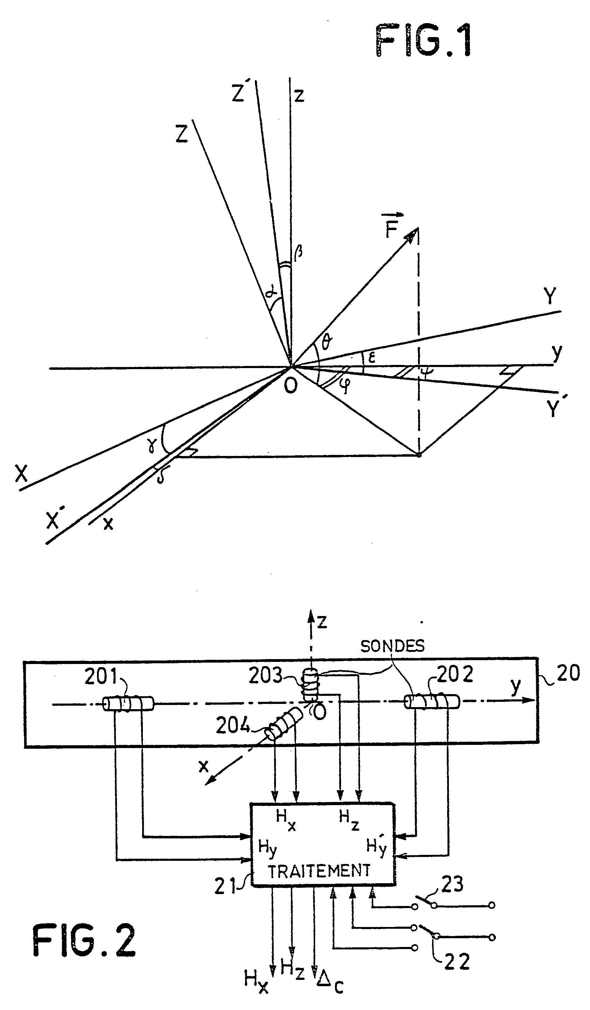

Afin de pouvoir évaluer l'erreur due au défaut de colinéarité, on a représenté sur la figure 1 un trièdre de référence trirectangle Oxyz dont l'axe oy est celui de l'un des magnétomètres d'un gradientmètre.

Un second trièdre OXYZ est défini par l'axe OY du deuxième magnétomètre du gradientmètre et par les axes OX et OZ de deux autres magnétomètres dont le rôle sera défini ultérieurement. Ce second trièdre est légèrement distinct du premier et donc non trirectangle, à cause des erreurs, inévitables, d'orientation des magnétomètres qui le définissent.

Les projections X' et Y' des axes X et Y sur le plan oxy, et Z' de l'axe Z sur le plan yoz sont définies par les angles γ, δ, ε, ψ, α et β représentés sur la figure 1.

Le champ magnétique dont on désire mesurer le gradient est représenté par un vecteur $\vec{F}$ dont l'orientation est définie par les angles θ et φ représentés sur cette figure.

Avec ces définitions, les composantes du champ sur les six axes ainsi définis sont données par :

Hx = F cos θ sin φ
Hy = F cos θ cos φ
Hz = F sin θ
HX = F [cos θ sin φ cos δ cos γ — cos θ cos φ sin δ cos γ + sin θ sin γ]
HY = F [cos θ cos φ cos ψ cos ε + cos θ sin φ sin ψ cos ε + sin θ sin ε]
HZ = F [sin θ cos β cos α — cos θ cos φ sin β cos α — cos θ sin φ sin α]

Le gradientmètre formé par les deux magnétomètres d'axes oy et OY donne une mesure du gradient du champ dans une direction intermédiaire entre ces deux axes. L'erreur portant sur la direction est peu importante mais il reste à apprécier l'erreur portant sur la mesure elle-même.

Si le champ est uniforme, et donc le gradient nul, la différence des mesures des deux magnétomètres devrait être nulle. Ce n'est pas le cas à cause de l'erreur de colinéarité et on obtient une valeur donnée

2

par :

$$\Delta = HY - Hy = F \left[\cos \theta \cos \varphi (\cos \psi \cos \varepsilon - 1) + \cos \theta \sin \varphi \sin \psi \cos \varepsilon + \sin \theta \sin \varepsilon\right]$$

Cette différence mesure donc l'erreur de colinéarité suivant Oy et est formée de trois termes qui prennent des valeurs maximales selon l'orientation du gradientmètre.

Dans le champ terrestre (F = 50 000 nT) et avec des valeurs (courantes) de $\varepsilon$ et $\psi$ égales à 0,2 degré, ces valeurs maximales sont respectivement :

   0,6 nT pour $\varphi = \delta = 0$
   175  nT pour $\theta = 0$ et $\varphi = \pi/2$
   135  nT pour $\theta = \pi/2$ et $\varphi$ quelconque.

Or les magnétomètres, par exemple du type dit « flux-gate », utilisés dans les gradientmètres ont des sensibilités bien plus faibles, typiquement inférieures à 0,1 nT. Il est donc tout à fait nécessaire de corriger au moins les deux derniers termes de l'erreur.

Pour cela selon l'invention on effectue un étalonnage qui permet de déterminer les paramètres constants de ces deux termes. Cet étalonnage permet ensuite de calculer ces termes et de les retrancher de la mesure pour obtenir une mesure corrigée.

Ces paramètres constants sont ceux qui dépendent des angles $\psi$ et $\varepsilon$, soit $\sin \psi \cos \varepsilon$ pour le premier terme et $\sin \varepsilon$ pour le deuxième terme.

On peut isoler ces paramètres pour des valeurs particulières des angles $\theta$ et $\varphi$. On obtient alors pour 4 orientations du gradientmètre les valeurs suivantes de $\Delta$, Hx et Hz :

$\theta = 0$ et $\varphi = \pi/2 \longrightarrow \Delta_1 = F \sin \psi \cos \varepsilon$ ; Hz = 0 ; Hx = F
$\theta = \pi/2$ et $\varphi = \pi/2 \longrightarrow \Delta_2 = F \sin \varepsilon$ ; Hx = 0 ; Hz = F
$\theta = \pi$ et $\varphi = \pi/2 \longrightarrow \Delta_3 = -F \sin \psi \cos \varepsilon$ ; Hz = 0 ; Hx = — F
$\theta = 3\pi/2$ et $\varphi = \pi/2 \longrightarrow \Delta_4 = -F \sin \varepsilon$ ; Hx = 0 ; Hz = — F

Ces quatre orientations peuvent être obtenues en plaçant le gradientmètre dans le champ terrestre avec une orientation Est-Ouest de son axe, ce qui donne $\varphi = \pi/2$ et Hy = 0. En faisant alors tourner le gradientmètre autour de cet axe Oy, on obtiendra les quatre orientations voulues en mesurant les extinctions des signaux de deux magnétomètres supplémentaires placés selon deux axes perpendiculaires à Oy. Lorsque l'un de ces magnétomètres délivre un signal nul, l'autre délivre un signal qui mesure F ou — F selon le cas. Ceci permet de calculer :

$$\sin \psi \cos \varepsilon = \frac{\Delta_1}{F} = -\frac{\Delta_3}{F}$$

$$\sin \varepsilon = \frac{\Delta_2}{F} = -\frac{\Delta_4}{F}$$

On constate qu'il suffit dans le cas d'un gradient nul de deux mesures selon deux orientations orthogonales.

En fait le gradient est rarement nul et de plus on n'a pas tenu compte de l'erreur de positionnement des deux gradientmètres supplémentaires, correspondant en fait aux angles $\alpha$, $\beta$, $\gamma$ et $\delta$, ce qui est en partie justifié par la faiblesse de ces angles.

En présence d'un gradient local $\Delta e$, la valeur mesurée $\Delta m$ est donnée par $\Delta m = \Delta e + \Delta$.

Lorsque l'on fait tourner le gradientmètre autour de son axe y, le gradient local $\Delta e$ reste constant, mais $\Delta$ prend successivement les quatre valeurs précédentes et on peut alors éliminer $\Delta e$, et en même temps moyenner les erreurs de positionnement :

$$\frac{\Delta_e + \Delta_1 - \Delta_e - \Delta_3}{2F} = \frac{\Delta_1 - \Delta_3}{2F} = \sin \psi \cos \varepsilon = k_x$$

$$\frac{\Delta_e - \Delta_2 - \Delta_e - \Delta_4}{2F} = \frac{\Delta_2 - \Delta_4}{2F} = \sin \varepsilon = k_z$$

Ces paramètres étant déterminés, on peut mesurer le gradient $\Delta m$ pour une orientation ($\theta$, $\varphi$) quelconque du gradientmètre, et obtenir par ailleurs les deux valeurs $Hx_m$ et $Hz_m$ des composantes de F données par les deux magnétomètres supplémentaires.

En tenant compte de ce que $Hx_m = F \cos \theta \sin \varphi$ et $Hz_m = F \sin \theta$, la valeur $\Delta c$ du gradient corrigé sera alors donnée par :

$$\Delta c = \Delta m - k_x Hx_m - k_z Hz_m$$

3

Le gradientmètre selon l'invention comporte donc comme représenté sur la figure 2 une première partie sondes 20 comprenant deux magnétomètres 201 et 202 alignés sur un axe oy et permettant de mesurer le gradient selon la méthode connue, et deux magnétomètres 203 et 204 disposés selon deux axes ox et oz perpendiculaires entre eux et à l'axe oy.

Une deuxième partie 21 comprend d'une part des circuits électroniques destinés à alimenter les magnétomètres et à obtenir les signaux Hy, H'y, Hx et Hz, et d'autre part des circuits électroniques permettant à partir de ces signaux de calculer la valeur de $\Delta c$ qui est disponible sur une sortie. Ces circuits électroniques de calcul permettent également de calculer dans un premier temps les valeurs des coefficients $k_x$ et $k_z$ lorsque l'on procède à l'étalonnage. Pour cela un interrupteur 22 permet de passer d'une position mesure à une position calibration, et dans cette position un bouton poussoir 23 par exemple permet de prendre en compte les valeurs de Hz et Hz obtenues dans les quatre positions d'étalonnage. Pour cela, l'axe oy du gradientmètre étant orienté selon une direction Est-Ouest, on le fait tourner suivant cet axe oy jusqu'à ce que l'une des sorties Hx ou Hz délivre un signal nul. On presse alors sur le bouton poussoir 23 pour prendre en compte la valeur non nulle de Hx ou Hz. On continue ensuite à tourner le gradientmètre sur son axe oy pour recommencer cette manipulation trois fois.

On a constaté que la tolérance sur l'orientation Est-Ouest lors de l'étalonnage était très large et pouvait atteindre 30° en permettant de mesurer un gradient de 1 nT dans le champ terrestre (50 000 nT).

Dans le cas de circuits analogiques on peut simplifier les circuits contenus dans la partie 21 en effectuant l'étalonnage avec des moyens séparés, par exemple des appareils de mesure de laboratoire. Les valeurs des coefficients $k_x$ et $k_z$ seront alors calculées manuellement et introduites dans la partie 21, par exemple en réglant des potentiomètres. Ceci est justifié par le fait que ces coefficients sont des constantes qui ne dépendent pas des conditions de mesures et qui n'évoluent que très lentement en fonction du vieillissement des sondes de la partie 20.

Ce traitement peut être réalisé à l'aide de circuits numériques, formés avantageusement d'un microprocesseur convenablement programmé. Il est alors plus intéressant d'intégrer les moyens de calibration dans le dispositif puisque ceux-ci peuvent alors être formés d'une simple extension du programme du microprocesseur, ce qui permet de se passer des moyens extérieurs et de répéter l'étalonnage aussi souvent qu'on le souhaite.

## Revendications

1. Procédé de compensation automatique des erreurs mécaniques d'un gradientmètre magnétique, dans lequel on mesure le gradient $\Delta m$ selon une direction oy, d'un champ F d'orientation quelconque, en soustrayant à la mesure de la composante Hy de F, obtenue par un premier magnétomètre de mesure (201) aligné selon l'axe oy, la mesure de la composante H'y de F, obtenue par un deuxième magnétomètre de mesure (202) situé à une faible distance du premier et aligné selon un axe OY présentant avec l'axe oy une légère erreur d'alignement, on soustrait de $\Delta m$ deux termes d'erreur $k_x Hx_m$ et $k_z Hz_m$ dans lesquels $k_x$ et $k_z$ sont deux coefficients et Hx et Hz les mesures des composantes de F obtenues par deux magnétomètres supplémentaires (203, 204) alignés selon deux axes ox et oz perpendiculaires entre eux et perpendiculaires à l'axe oy, caractérisé en ce que l'on effectue un étalonnage permettant d'obtenir les coefficients $k_x$ et $k_z$ en orientant l'axe oy du gradientmètre (20) selon une direction Est-Ouest dans le champ magnétique terrestre puis on fait tourner le gradientmètre autour de son axe oy et l'on relève quatre mesures $\Delta 1$, $\Delta 2$, $\Delta 3$ et $\Delta 4$ pour lesquelles respectivement le premier et le deuxième, puis de nouveau le premier et le deuxième magnétomètre supplémentaire (203-204) donnent une mesure nulle et le deuxième et le premier magnétomètre supplémentaire donnent alors une valeur F, puis une valeur $- F$ ; les coefficients étant alors donnés par :

$$k_x = \frac{\Delta_1 - \Delta_3}{2\,F} \quad \text{et} \quad k_z = \frac{\Delta_2 - \Delta_4}{2\,F}$$

2. Procédé selon la revendication 1, caractérisé en ce que, le gradient local du champ magnétique terrestre selon la direction Est-Ouest étant nul au moment et à l'endroit de l'étalonnage ce qui entraîne que $\Delta 1 = \Delta 3$ et $\Delta 2 = \Delta 4$, on ne relève que deux mesures $\Delta 1$ et $\Delta 2$ pour lesquelles respectivement le premier et le deuxième magnétomètre supplémentaire (203-204) donnent une valeur nulle et le deuxième et le premier magnétomètre supplémentaire donnent alors une valeur F ; les coefficients étant alors donnés par

$$k_x = \frac{\Delta_1}{F} \quad \text{et} \quad k_z = \frac{\Delta_2}{F}$$

## Claims

4

**0 156 086**

1. An automatic compensation method of mechanical errors in a magnetic gradient meter in which the gradient $\Delta m$ of a field F of any orientation is measured along an axis oy, by subtracting from the component Hy of F measured by a first magnetometer (201) aligned along the axis oy, the component H'y of F measured by a second magnetometer (202) situated at a short distance from the first one and aligned according to an axis OY presenting a slight alignment error with the axis oy, from $\Delta m$ two error values $k_x Hx_m$ and $k_z Hz_m$ are subtracted, wherein $k_x$ and $k_z$ are two factors and Hx and Hz are the components of F measured by two additional magnetometers (203, 204) aligned along two mutually perpendicular axes ox and oz, which are further perpendicular to the axis oy, characterized in that a calibration is performed allowing to obtain the factors $k_x$ and $k_z$ by aligning the axis oy of the gradient meter (20) along an east-west direction in the magnetic earth field, that then the gradient meter is turned about its axis oy and that four values $\Delta 1$, $\Delta 2$, $\Delta 3$, $\Delta 4$ are measured, for which the first and the second, and then again the first and the second additional magnetometer (203-204) indicate a measuring value zero, and the second and the first additional magnetometer indicate then a value F, then a value $-$ F, the factors being then determined by

$$k_x = \frac{\Delta_1 - \Delta_3}{2\,F} \quad \text{and} \quad k_z = \frac{\Delta_2 - \Delta_4}{2\,F}$$

2. A method according to claim 1, characterized in that the local gradient of the magnetic earth field along the direction east-west being zero at the calibration instant and at the calibration point, which signifies $\Delta 1 = \Delta 3$ and $\Delta 2 = \Delta 4$, only two values $\Delta 1$ and $\Delta 2$ are measured, for which the first and the second additional magnetometers (203-204) indicate a value zero and the second and the first additional magnetometers indicate a value F, the factors being then defined by

$$k_x = \frac{\Delta_1}{F} \quad \text{and} \quad k_z = \frac{\Delta_2}{F}$$

## Patentansprüche

1. Verfahren zur automatischen Kompensation der mechanischen Fehler eines magnetischen Gradientenmessers, in dem der Gradient $\Delta m$ eines Feldes F beliebiger Orientierung gemäß einer Richtung oy gemessen wird, indem vom Meßwert der Komponente Hy von F, die durch eine erstes mit der Achse oy fluchtendes Magnetometer (201) gemessen wird, die Komponente H'y von F abgezogen wird, die durch ein zweites Magnetometer (202) gemessen wird, das in geringem Abstand vom ersten und fluchtend mit einer Achse OY angeordnet ist, welche mit der Achse oy einen kleinen Fluchtungsfehler einschließt, worauf von $\Delta m$ zwei Fehlergrößen $k_x Hx_m$ und $k_z Hz_m$ abgezogen werden, in denen $k_x$ und $k_z$ zwei Koeffizienten und Hx sowie Hz die Komponenten von F sind, die in zwei zusätzlichen Magnetometern (203, 204) gemessen werden, die gemäß zwei zueinander orthogonalen und zur Achse oy senkrechten Achsen ox und oz angeordnet sind, dadurch gekennzeichnet, daß eine Eichung durchgeführt wird, mit der die Koeffizienten $k_x$ und $k_z$ erhalten werden, indem die Achse oy des Gradientenmessers (20) in Ost-West-Richtung im magnetischen Erdfeld ausgerichtet wird, worauf der Gradientenmesser um seine Achse oy gedreht, wird und vier Messungen $\Delta 1$, $\Delta 2$, $\Delta 3$, $\Delta 4$ durchgeführt werden, für die das erste bzw. zweite, dann erneut das erste und das zweite zusätzliche Magnetometer (203-204) einen Wert Null ergeben, worauf das zweite zusätzliche und das erste zusätzliche Magnetometer einen Wert F, dann einen Wert $-$ F liefern, woberi die Koeffizienten sich ergeben gemäß

$$k_x = \frac{\Delta_1 - \Delta_3}{2\,F} \quad \text{und} \quad k_z = \frac{\Delta_2 - \Delta_4}{2\,F}$$

2. Verfahren nach Anspruchen 1, dadurch gekennzeichnet, daß, wenn der örtliche Gradient des Erdmagnetfelds in Ost-West-Richtung im Eichaugenblick und an der Eichstelle Null ist, woraus folgt $\Delta 1 = \Delta 3$ und $\Delta 2 = -\Delta 4$, nur zwei Messungen $\Delta 1$ und $\Delta 2$ erfaßt werden, für die das erste zusätzliche und das zweite zusätzliche Magnetometer (203-204) einen Wert Null angeben und der zweite zusätzliche und der erste zusätzliche Magnetometer dann einen Wert F liefern, so daß die Koeffizienten sich ergeben gemäß

$$k_x = \frac{\Delta_1}{F} \quad \text{und} \quad k_z = \frac{\Delta_2}{F}$$

5

# FIG.1

# FIG.2